# EUROPEAN PATENT APPLICATION

(11) **EP 4 636 770 A1**
(43) Date of publication of application: **22.10.2025**
(21) Application number: 25165321.8
(22) Date of filing: 21.03.2025
(51) Int. Cl.: G11C 29/00, G06F 11/10, G11C 29/04, G11C 29/44, G11C 29/52

(54) **SEMICONDUCTOR DEVICE AND METHOD OF REPAIRING THE SAME**

(30) Priority: 15.04.2024 KR 20240050315; 24.05.2024 KR 20240067978
(71) Applicant: Samsung Electronics Co., Ltd., Suwon-si, Gyeonggi-do 16677 (KR)
(72) Inventor: LEE, Juyeon, 16677 Suwon-si (KR); PARK, Sungcheol, 16677 Suwon-si (KR)
(74) Representative: Marks & Clerk LLP

(57) **Abstract**

A semiconductor device includes a host and a memory device including a first memory cell array corresponding to a plurality of word lines and a second memory cell array corresponding to a plurality of redundancy word lines. The host is configured to, based on an occurrence of a first type of error that is correctable through an error correction code (ECC) in a first memory cell row connected to a first word line in the first memory cell array, correct the first type of error through the error correction code. The host is configured to, based on a number of the occurrence of the first type of error in the first memory cell row exceeding a predetermined threshold value, deactivate the first word line and activate a first redundancy word line corresponding to the first word line among the plurality of redundancy word lines.

## Description

### BACKGROUND

One or more example embodiments of the disclosure relate to a semiconductor device and a method of repairing the same.

Volatile memory devices, such as a dynamic random access memory (DRAM), are used to store large amounts of data such as a system memory. In addition, in volatile semiconductor memory devices such as the DRAM, a process scale is reduced to increase the degree of integration.

In general, as a DRAM manufacturing process becomes more refined, the number of defective memory cells, that is, defective cells, increases. A repair method that replaces the defective cells with spare cells or redundancy cells provided separately from normal cells may be employed as a method to repair the defective cells for improving the reliability of the DRAM.

As an example, a repair method may replace a row in which defective cells are arranged with a spare row or a redundancy row or replace a column in which defective cells are arranged with a spare column or a redundancy column.

### SUMMARY

One or more example embodiments of the disclosure provide a semiconductor device including a memory device having an improved reliability and a method of repairing the memory device.

According to an aspect of an example embodiment of the disclosure, a semiconductor device includes a host and a memory device including a first memory cell array corresponding to a plurality of word lines and a second memory cell array corresponding to a plurality of redundancy word lines. The host may be configured to, based on an occurrence of a first type of error that is correctable through an error correction code (ECC) in a first memory cell row connected to a first word line in the first memory cell array, correct the first type of error through the error correction code. The host may be configured to, based on a number of the occurrence of the first type of error in the first memory cell row exceeding a predetermined threshold value, deactivate the first word line and activate a first redundancy word line corresponding to the first word line among the plurality of redundancy word lines.

According to an aspect of an example embodiment of the disclosure, a method of repairing a memory device includes detecting an occurrence of an error in a first memory cell row connected to a first word line of a first memory cell array included in the memory device; correcting, based on the detected error being of a first type that is correctable through an error correction code (ECC), the first type of error through the error correction code; and deactivating the first word line and activating a first redundancy word line corresponding to the first word line, based on a number of an occurrence of the first type of error in the first memory cell row exceeding a predetermined threshold value.

According to an aspect of an example embodiment of the disclosure, a semiconductor device includes a host and a memory device including a first memory cell array corresponding to a plurality of word lines and a second memory cell array corresponding to a plurality of redundancy word lines. The host may be configured to detect an error occurring in a first memory cell row connected to a first word line of the first memory cell array; and the host may be configured to, based on a number of an occurrence of a first type of error, which is correctable through an error correction code, in the first memory cell row exceeding a predetermined threshold value, deactivate the first word line and activate a first redundancy word line corresponding to the first word line among the plurality of redundancy word lines.

At least some of the above and other features of the invention are set out in the claims.

### BRIEF DESCRIPTION OF DRAWINGS

The above and other objects and features of the disclosure will become apparent by describing in detail embodiments thereof with reference to the accompanying drawings.
FIG. 1 is a block diagram illustrating a semiconductor device according to one or more example embodiments of the disclosure;
FIG. 2A is a block diagram illustrating a semiconductor device according to one or more example embodiments of the disclosure;
FIG. 2B is a block diagram illustrating a semiconductor device according to one or more example embodiments of the disclosure;
FIG. 3 is a block diagram illustrating a semiconductor device in which an error is corrected through an error correction code (ECC) when a first type of error occurs in a memory cell row according to one or more example embodiments of the disclosure;
FIG. 4 is a block diagram illustrating a semiconductor device in which a first word line is deactivated and a first redundancy word line is activated according to one or more example embodiments of the disclosure;
FIG. 5 is a block diagram illustrating a semiconductor device in which a first word line is deactivated and a first redundancy word line is activated according to one or more example embodiments of the disclosure;
FIG. 6 is a block diagram illustrating a semiconductor device in which a first word line is blocked according to one or more example embodiments of the disclosure;
FIG. 7 is a block diagram illustrating a semiconductor device in which a first word line is blocked according to one or more example embodiments of the disclosure;
FIG. 8 is a flowchart illustrating a method of repairing a memory device according to one or more example embodiments of the disclosure;
FIG. 9A is a flowchart illustrating a method of deactivating a first word line and activating a first redundancy word line after a first memory cell row is transitioned to an idle state according to one or more example embodiments of the disclosure;
FIG. 9B is a flowchart illustrating a method of deactivating a first word line and activating a first redundancy word line in response to a self-refresh command according to one or more example embodiments of the disclosure;
FIG. 10 is a flowchart illustrating a method of repairing a memory device depending on the type of error according to one or more example embodiments of the disclosure;
FIG. 11 is a flowchart illustrating operations of blocking a first word line and cutting off power supplied to a memory device in response to a shutdown command according to one or more example embodiments of the disclosure;
FIG. 12 is a perspective view illustrating a semiconductor device according to one or more example embodiments of the disclosure;
FIG. 13 is a cross-sectional view illustrating a semiconductor device according to one or more example embodiments of the disclosure;
FIG. 14 is a block diagram illustrating a semiconductor device that corrects errors of a memory device; and
FIG. 15 is a block diagram illustrating a semiconductor device according to one or more example embodiments of the disclosure.

### DETAILED DESCRIPTION

Below, example embodiments of the disclosure will be described in detail and clearly to such an extent that a person of ordinary skill in the art can easily implement the disclosure.

In addition, expressions such as "first," "second," and the like used in the disclosure describe various components regardless of their order and/or importance, and the expressions are used only to distinguish one component from another component and do not limit the order of importance of the components.

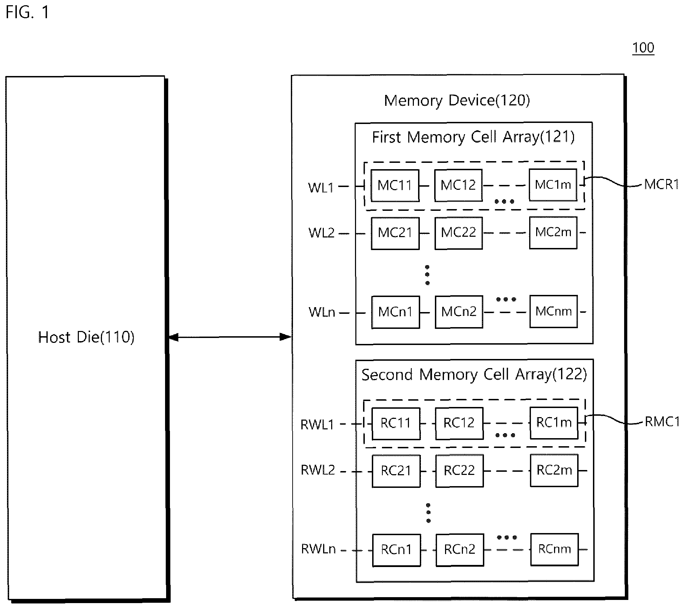

FIG. 1 is a block diagram illustrating a semiconductor device 100 according to one or more example embodiments of the disclosure.

Referring to FIG. 1, the semiconductor device 100 may include a host (e.g., host die) 110 and a memory device 120.

In detail, the semiconductor device 100 may include the host 110 to control the memory device 120.

The host 110 may write data in the memory device 120 or read data from the memory device 120. That is, the host 110 may perform various data input/output (I/O) operations on the memory device 120.

In addition, the host 110 may execute applications supported by the semiconductor device 100 using the memory device 120.

That is, the host 110 may be configured to control an overall operation of the memory device 120. Accordingly, the host 110 may be referred to as a logic chip, a logic die, a host die, or the like. According to one or more example embodiments, the host 110 may be a system-on-chip (SoC). In addition, the semiconductor device 100 may include the memory device 120 configured to store data.

In more detail, the memory device 120 may store data input thereto from an outside thereof. In addition, the memory device 120 may output the stored data in response to a read request from the outside.

In some embodiments, the memory device 120 may include a dynamic random access memory (DRAM), such as a double data rate synchronous dynamic random access memory (DDR SDRAM), a low power double data rate synchronous dynamic random access memory (LPDDR SDRAM), a graphics double data rate synchronous dynamic random access memory (GDDR SDRAM), a Rambus dynamic random access memory (RDRAM), or the like, however, the memory device 120 should not be limited thereto or thereby. According to one or more example embodiments, the memory device 120 may be a nonvolatile memory, such as a flash memory, a magnetic RAM (MRAM), a ferroelectric RAM (FeRAM), a phase change RAM (PRAM), and a resistive RAM (RRAM), or the like.

Hereinafter, for the sake of explanation, the DRAM will be described as an example of the memory device 120.

The memory device 120 may be a high bandwidth memory (HBM) formed by stacking a plurality of memory dies. Each of the memory dies included in the memory device 120 may be an HBM DRAM device.

The memory device 120 may include a first memory cell array 121 and a second memory cell array 122.

In more detail, the memory device 120 may include the first memory cell array 121 corresponding to a plurality of word lines WL1, WL2, ... WLn. In addition, the memory device 120 may include the second memory cell array 122 corresponding to a plurality of redundancy word lines RWL1, RWL2, ... RWLn.

As an example, the first memory cell array 121 may include a first memory cell row MCR1 corresponding to a first word line WL1. In this case, the first memory cell row MCR1 may include a plurality of first memory cells MC11, MC12, ... MC1m connected to the first word line WL1.

As an example, the second memory cell array 122 may include a first redundancy memory cell row RMC1 corresponding to a first redundancy word line RWL1. In this case, the first redundancy memory cell row RMC1 may include a plurality of first redundancy memory cells RC11, RC12, ... RC1m connected to the first redundancy word line RWL1.

The host 110 may store data in the memory cells MC11 to MCnm included in the first memory cell array 121 and/or may read the data stored in the memory cells MC11 to MCnm.

The host 110 may determine whether an error occurs in at least one of the memory cells MC11 to MCnm.

As an example, the host 110 may determine that an error occurs in a certain memory cell when data (or a bit value of the data) written in the certain memory cell and data read from the certain memory cell are different from each other.

In addition, when the error occurs in at least one of the memory cells MC11 to MCnm, the host 110 may correct the error using an error correction code (ECC).

According to one or more example embodiments, when a first type of error that is correctable through the ECC occurs in the first memory cell row MCR1 of the first memory cell array 121, the host 110 may correct the first type of error using the ECC.

As an example, the first type of error may be an error that occurs in a number of a bit equal to or less than a maximum number of a bit (e.g., "1") that is correctable through the ECC by the host 110, but the first type of error should not be limited thereto or thereby.

Accordingly, when the maximum number of a bit correctable through the ECC by the host 110 is 1 and a 1-bit error occurs in the first memory cell row MCR1, the host 110 may correct the error using the ECC.

When a number of the first type of errors occurring in the first memory cell row MCR1 exceeds a threshold value, the host 110 may replace the first memory cell row MCR1 with the first redundancy memory cell row RMC1 of the second memory cell array 122, which corresponds to the first memory cell row MCR1.

In more detail, the host 110 may deactivate the first word line WL1 connected to the first memory cell row MCR1 where the number of the first type of error occurring exceeds the threshold value.

In addition, the host 110 may activate the first redundancy word line RWL1 corresponding to the deactivated first word line WL1.

Accordingly, the host 110 may replace the first memory cell row MCR1 with the first redundancy memory cell row RMC1.

That is, the host 110 may write data in a first-first redundancy memory cell RC11 instead of a first-first memory cell MC11 or may read data from the first-first redundancy memory cell RC11 instead of the first-first memory cell MC11.

On the other hand, according to one or more example embodiments, when a second type of error that is uncorrectable through the ECC occurs in the first memory cell row MCR1, the host 110 may block the first word line WL1.

In the present embodiment, the second type of error may be an error that occurs in a number of a bit exceeding the maximum number of a bit (e.g., "1") that is correctable through the ECC by the host 110, but the second type of error should not be limited thereto or thereby.

Accordingly, when the maximum number of a bit correctable through the ECC by the host 110 is 1 and a 2-bit error occurs in the first memory cell row MCR1, the host 110 may disconnect the first word line WL1.

In addition, an operation of the host 110 to disconnect the first word line WL1 may include an operation of physically disconnecting a path between the host 110 and the first word line WL1.

Accordingly, the operation of the host 110 to block the first word line WL1 may be referred to as a fusing operation.

In addition, the host 110 may activate the first redundancy word line RWL1 corresponding to the first word line WL1.

Further, the host 110 may cut off a power supplied to the memory device 120 in response to the first word line WL1 being disconnected from the host 110.

That is, when the second type of error occurs in the first memory cell row MCR1, the host 110 may write or read data using the first redundancy memory cell row RMC1 instead of the first memory cell row MCR1.

Based on the above-described configuration, when the number of the first type of error, which is correctable through the ECC, occurring in the first memory cell row MCR1, exceeds the threshold value, the host 110 may deactivate the first word line WL1.

In addition, the host 110 may activate the first redundancy word line RWL1 corresponding to the first word line WL1.

That is, the host 110 may replace the first memory cell row MCR1 with the first redundancy memory cell row RMC1 based on an occurrence of the first type of error that is correctable through the ECC without the physical disconnection or fusing operation.

Accordingly, the host 110 may reduce a probability of an occurrence of the second type of error that is uncorrectable through the ECC in the memory device 120.

Further, the host 110 may reduce a number of times the host 110 cuts off the power supplied to the memory device 120 to correct the second type of error occurring in the memory device 120.

Accordingly, the host 110 may reduce a performance degradation of the memory device 120 caused by cutting off the power supplied to the memory device 120.

As described above, a reliability of the memory device 120 of the semiconductor device 100 may be improved. In addition, the semiconductor device 100 may enhance a performance of the memory device 120.

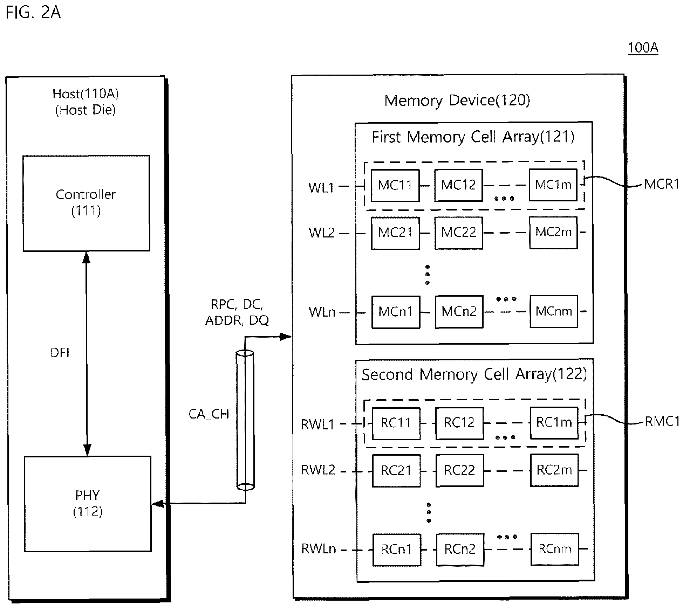

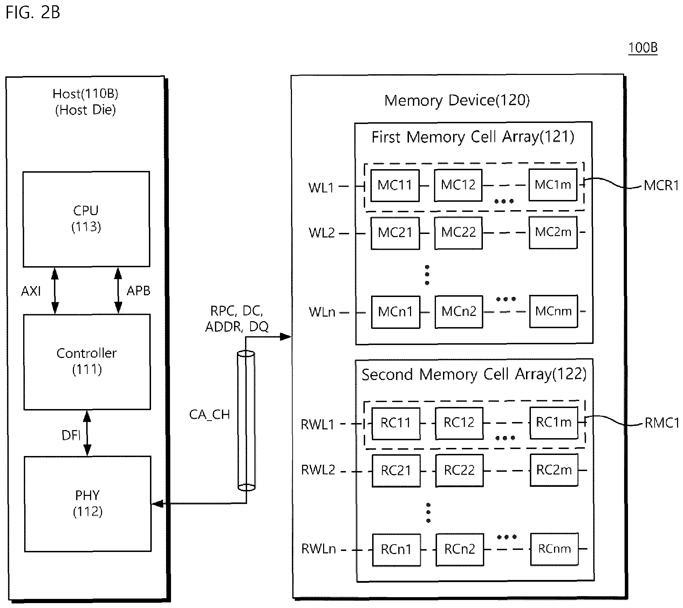

FIG. 2A is a block diagram illustrating a semiconductor device 100A according to one or more example embodiments of the disclosure, and FIG. 2B is a block diagram illustrating a semiconductor device 100B according to one or more example embodiments of the disclosure.

Referring to FIG. 2A, the semiconductor device 100A may include a host 110A and a memory device 120. The host 110A may include a controller 111 and a physical layer (hereinafter, referred to as PHY) 112.

In the present embodiment, the semiconductor device 100A and the host 110A shown in FIG. 2A may be understood as examples of the semiconductor device 100 and the host 110 of FIG. 1.

Accordingly, in FIG. 2A, the same reference numerals may denote the same elements in FIG. 1, and thus, detailed descriptions of the same elements will be omitted.

The host 110A may include the controller 111 to control an operation of the memory device 120.

The controller 111 may execute software (e.g., a program) to control at least one component (e.g., a first word line WL1) of the memory device 120 and may perform various data processing or computation.

In addition, the controller 111 may include a central processing unit (CPU) or a microprocessor and may control an overall operation of the host 110A with respect to the memory device 120. Accordingly, an operation performed on the memory device 120 by the host 110A may be performed under the control of the controller 111.

Further, the host 110A may include the PHY 112 connected between the controller 111 and the memory device 120.

The PHY 112 may communicate with the controller 111 and/or the memory device 120.

In more detail, the PHY 112 may transmit and receive at least one of a repair command RPC, a data command DC, an address ADDR, and data DQ to and from the controller 111 through a DFI (DDR PHY interface).

In addition, the PHY 112 may transmit and receive at least one of the repair command RPC, the data command DC, the address ADDR, and the data DQ to and from the memory device 120 through a command/address channel CA_CH.

As an example, the PHY 112 may transmit the repair command RPC and the address ADDR provided from the controller 111 to the memory device 120 through the command/address channel CA_CH.

However, the interface and channel through which the PHY 112 transmits and receives the data DQ, the command RPC, data command DC, and the address ADDR to and from the controller 111 and the memory device 120 should not be limited to the above-described embodiment.

Referring to FIG. 2B, the semiconductor device 100B may include a host 110B and a memory device 120. In addition, the host 110B may include a controller 111, a PHY 112, and a central processing unit (CPU) 113.

In the present embodiment, the semiconductor device 100B shown in FIG. 2B may be understood as an example of the semiconductor device 100 shown in FIG. 1. In addition, the host 110B shown in FIG. 2B may be understood as a configuration in which the CPU 113 is added to the host 110A shown in FIG. 2A.

Accordingly, in FIG. 2B, the same reference numerals may denote the same elements in FIGS. 1 and 2A, and thus, detailed descriptions of the same elements will be omitted.

The host 110B may include the CPU 113 configured to control an operation of the host 110B.

In the present embodiment, the CPU 113 may be a part of a plurality of master intellectual properties provided in the host 110B. That is, the CPU 113 may execute applications supported by the semiconductor device 100B.

In more detail, the CPU 113 may control an operation of the host 110B through the controller 111.

The CPU 113 may be connected to the controller 111 through an advanced extensible interface AXI and an advanced peripheral bus APB.

In more detail, the CPU 113 may transmit data DQ, a data command DC, and an address ADDR to the controller 111 through the advanced extensible interface AXI. In addition, the CPU 113 may transmit a repair command RPC and the address ADDR to the controller 111 through the advanced peripheral bus APB.

However, the type and method of the interface through which the CPU 113 and the controller 111 are connected to each other should not be limited to the above-described embodiments.

Referring to FIGS. 2A and 2B, when a first type of error occurs in a first memory cell array 121, the controller 111 may correct the error using an error correction code (ECC).

The first type of error may be an error that is correctable by the controller 111 through the ECC.

When the number of the first type of error occurring in a first memory cell row MCR1 exceeds a threshold value, the controller 111 may replace the first memory cell row MCR1 with a first redundancy memory cell row RMC1 of a second memory cell array 122, which corresponds to the first memory cell row MCR1.

The controller 111 may deactivate a first word line WL1 connected to the first memory cell row MCR1 where the number of the first type of error occurring exceeds the threshold value.

In addition, the controller 111 may activate a first redundancy word line RWL1 corresponding to the first word line WL1.

Accordingly, the controller 111 may replace the first memory cell row MCR1 with the first redundancy memory cell row RMC1.

That is, as an example, the controller 111 may write data in a first-first redundancy memory cell RC11 instead of a first-first memory cell MC11 or may read data from the first-first redundancy memory cell RC11 instead of the first-first memory cell MC11.

On the other hand, according to one or more example embodiments, when a second type of error that is uncorrectable through the ECC occurs in the first memory cell row MCR1, the controller 111 may block the first word line WL1.

Further, the controller 111 may cut off a power supplied to the memory device 120 in response to the first word line WL1 being disconnected from the host 110B.

In addition, the controller 111 may activate the first redundancy word line RWL1 corresponding to the first word line WL1.

That is, when the second type of error occurs in the first memory cell row MCR1, the controller 111 may write data in or may read data from the first redundancy memory cell row RMC1.

According to the above-described configuration, when the number of the first type of error, which are correctable through the ECC, occurring in the first memory cell row MCR1 exceeds the threshold value, the controller 111 may deactivate the first word line WL1.

In addition, the controller 111 may activate the first redundancy word line RWL1 corresponding to the first word line WL1.

That is, the controller 111 may replace the first memory cell row MCR1 in which the error of the first type occurs more than the threshold value of times with the first redundancy memory cell row RMC1 without the physical disconnection or fusing operation.

In addition, the host 110B (or the controller 111) may replace the first memory cell row MCR1 with the first redundancy memory cell row RMC1 without changing the address ADDR for the memory device 120.

Accordingly, the controller 111 may reduce a probability of an occurrence of the second type of error that is uncorrectable through the ECC in the memory device 120.

Further, the controller 111 may reduce the number of times the controller 111 blocks the power supplied to the memory device 120 to correct the second type of error occurring in the memory device 120. Accordingly, the controller 111 may reduce a performance degradation of the memory device 120 caused by cutting off the power supplied to the memory device 120.

As described above, the reliability of the memory device 120 of the semiconductor devices 100A and 100B may be improved. In addition, the performance of the memory device 120 of the semiconductor devices 100A and 100B may be improved.

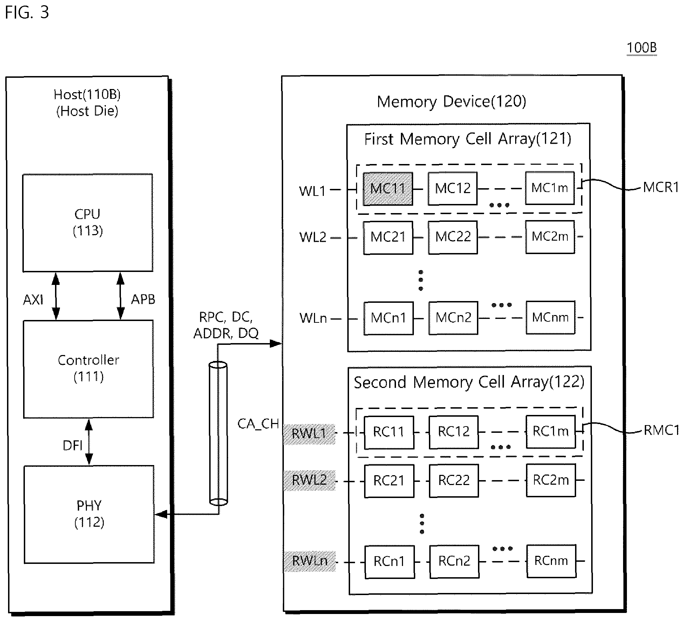

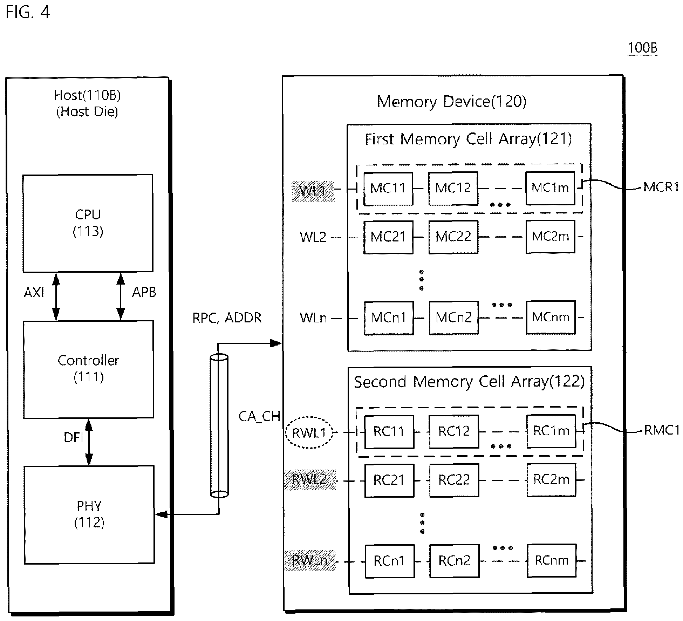

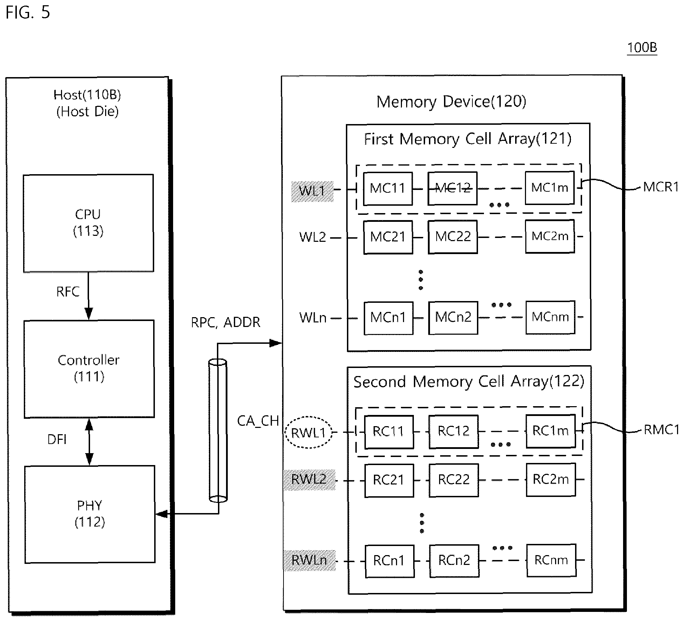

FIG. 3 is a block diagram illustrating the semiconductor device 100B in which the error is corrected through the ECC when the first type of error occurs in the memory cell row according to one or more example embodiments of the disclosure. FIG. 4 is a block diagram illustrating the semiconductor device 100B in which the first word line is deactivated and the first redundancy word line is activated according to one or more example embodiments of the disclosure. FIG. 5 is a block diagram illustrating the semiconductor device 100B in which the first word line is deactivated and the first redundancy word line is activated according to one or more example embodiments of the disclosure.

Referring to FIGS. 3 to 5, the semiconductor device 100B may include the host 110B and the memory device 120.

The semiconductor device 100B shown in FIGS. 3 to 5 may be substantially the same as the semiconductor device 100B shown in FIG. 2B.

Referring to FIG. 3, the controller 111 may determine whether the error occurs in at least one of the memory cells MC11 to MCnm.

The controller 111 may determine that the error occurs in the first-first memory cell MC11 when data (or a bit value of the data) written in the first-first memory cell MC11 and data (or a bit value of the data) read from the first-first memory cell MC11 are different from each other.

In addition, the controller 111 may determine whether the error occurring in the first memory cell row MCR1 is the first type of error. The first type of error may be, for example, the error correctable by the controller 111 using the ECC.

That is, the controller 111 may determine whether a number of a bit with an error in the first memory cell row MCR1 is less than or equal to a number of a bit (e.g., "1") correctable through the ECC by the controller 111.

As an example, when a 1-bit error occurs in the first memory cell row MCR1, the controller 111 may determine that the first type of error occurs in the first memory cell row MCR1.

In addition, when the first type of error occurs in the first memory cell row MCR1, the controller 111 may correct the error occurring in the first memory cell row MCR1 using the ECC.

As an example, the controller 111 may correct the error occurring in the first-first memory cell MC11 using the ECC.

Referring to FIG. 4, when the number of the first type of error occurring in the first memory cell row MCR1 exceeds the threshold value, the controller 111 may replace the first memory cell row MCR1 with the first redundancy memory cell row RMC1.

In more detail, when the number of the first type of error occurring in the first memory cell row MCR1 exceeds the threshold value, the controller 111 may deactivate the first word line WL1 connected to the first memory cell row MCR1.

In addition, the controller 111 may activate the first redundancy word line RWL1 corresponding to the first word line WL1.

The controller 111 may determine whether the first memory cell row MCR1 is in an idle state.

In more detail, the controller 111 may determine whether the first memory cell row MCR1 is in the idle state in response to the number of occurrences of the first type of error in the first memory cell row MCR1 exceeding the threshold value.

As an example, the controller 111 may determine whether the first memory cell row MCR1 is in the idle state through the command/address channel CA_CH connected to the PHY 112.

When it is determined that the first memory cell row MCR1 is in the idle state, the controller 111 may deactivate the first word line WL1 and may activate the first redundancy word line RWL1.

According to one or more example embodiments, when it is determined that the first memory cell row MCR1 is not in the idle state, the controller 111 may control the first memory cell row MCR1 to be in the idle state.

In more detail, when it is determined that the first memory cell row MCR1 is not in the idle state, the controller 111 may block the data command DC and/or the data DQ from being applied to the first memory cell row MCR1 to transition the first memory cell row MCR1 to the idle state.

In this case, the data command DC may be a signal including a read command to read data stored in the memory device 120 or a write command to write data in the memory device 120.

As an example, when it is determined that the first memory cell row MCR1 is not in the idle state, the controller 111 may block a first data command from being applied to the first memory cell row MCR1 to allow the first memory cell row MCR1 to be in the idle state.

Further, the controller 111 may deactivate the first word line WL1 and may activate the first redundancy word line RWL1 in response to the transition of the first memory cell row MCR1 to the idle state.

Accordingly, the controller 111 may replace the first memory cell row MCR1 with the first redundancy memory cell row RMC1.

As an example, the controller 111 may change the bit corresponding to the first word line WL1 in the address ADDR transmitted to the memory device 120 to correspond to the first redundancy word line RWL1.

That is, the controller 111 may write the data in the first-first redundancy memory cell RC11 instead of the first-first memory cell MC11 or may read the data from the first-first redundancy memory cell RC11 instead of the first-first memory cell MC11.

Based on the above-described configuration, when the number of the first type of error, which is correctable through the ECC, occurring in the first memory cell row MCR1 exceeds the threshold value, the controller 111 may deactivate the first word line WL1.

In addition, the controller 111 may activate the first redundancy word line RWL1 corresponding to the first word line WL1.

That is, the controller 111 may replace the first memory cell row MCR1 where the error of the first type occurs more than the threshold value of times with the first redundancy memory cell row RMC1 without the physical disconnection or fusing operation on the first memory cell row MCR1.

Accordingly, the controller 111 may reduce the probability of an occurrence of the second type of error that is uncorrectable through the ECC in the memory device 120.

Further, the controller 111 may reduce the number of times the controller 111 blocks the power supplied to the memory device 120 to correct the second type of error occurring in the memory device 120. Therefore, the controller 111 may reduce the performance degradation of the memory device 120 caused by cutting off the power supplied to the memory device 120.

As described above, the reliability of the memory device 120 of the semiconductor device 100 may be improved.

Referring to FIG. 5, the controller 111 may deactivate the first word line WL1 and may activate the first redundancy word line RWL1 in response to a self-refresh command RFC provided from the CPU 113.

In more detail, the controller 111 may deactivate the first word line WL1 in response to the self-refresh command RFC provided from the CPU 113 in a state where the number of the first type of errors occurring in the first memory cell row MCR1 exceeds the threshold value. In addition, the controller 111 may activate the first redundancy word line RWL1 in response to the self-refresh command RFC provided from the CPU 113.

In the present embodiment, the self-refresh command RFC may be a command to control the memory device 120 to operate in a self-refreshing mode, in which the memory device 120 performs a refresh operation on its own to maintain data while the host 110B is turned-off.

Further, the controller 111 may apply the self-refresh command RFC to the memory device 120 to allow the memory device 120 to operate in the self-refreshing mode in a state where the first word line WL1 is deactivated and the first redundancy word line RWL1 is activated.

According to the above, the controller 111 may replace the first memory cell row MCR1 with the first redundancy memory cell row RMC1 before (or immediately before) the memory device 120 operates in the self-refreshing mode.

Accordingly, the controller 111 may reduce a frequency of transitioning the first memory cell row MCR1 to the idle state to replace the first memory cell row MCR1 with the first redundancy memory cell row RMC1.

Accordingly, the semiconductor device 100B may reduce the performance degradation that occurs when at least a portion of the memory device 120 is transitioned to the idle state. That is, the reliability of the memory device 120 of the semiconductor device 100B may be improved.

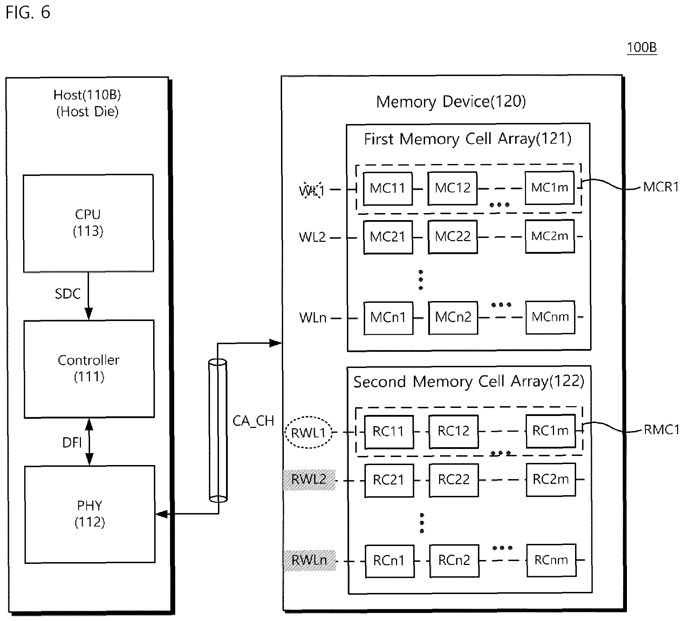

FIG. 6 is a block diagram illustrating the semiconductor device 100B in which the first word line is blocked according to one or more example embodiments of the disclosure.

Referring to FIG. 6, the controller 111 may block the first word line WL1.

In more detail, the controller 111 may block the first word line WL1 in a state where the first word line WL1 is deactivated and the first redundancy word line RWL1 is activated.

As an example, an operation of blocking the first word line WL1 by the controller 111 may be an operation that physically disconnects the path from the host 110B to the first word line WL1.

Accordingly, the operation of blocking the first word line WL1 by the controller 111 may be referred to as the fusing operation.

When the power supplied to the memory device 120 is cut off, the controller 111 may block the first word line WL1.

In more detail, the controller 111 may block the first word line WL1 in response to a shutdown command SDC applied thereto from the CPU 113.

In the present embodiment, the shutdown command SDC may be a command to cut off the power supplied to the memory device 120.

As an example, the controller 111 may cut off the power supplied to the memory device 120 in response to the shutdown command SDC and then may block a connection between the host 110B and the first word line WL1.

According to one or more example embodiments, the controller 111 may block the connection between the host 110B and the first word line WL1 in response to the shutdown command SDC applied thereto from the CPU 113. In addition, the controller 111 may block the connection between the host 110B and the first word line WL1 and then may cut off the power supplied to the memory device 120.

That is, when the word line connected to the memory cell row in which the first type of error occurs more than the threshold value of times is deactivated, the controller 111 may block the deactivated word line in response to the shutdown of the memory device 120.

Accordingly, the controller 111 may reduce the probability of the occurrence of errors when the memory device 120 restarts after being shut down.

Thus, the reliability of the memory device 120 of the semiconductor device 100B may be improved.

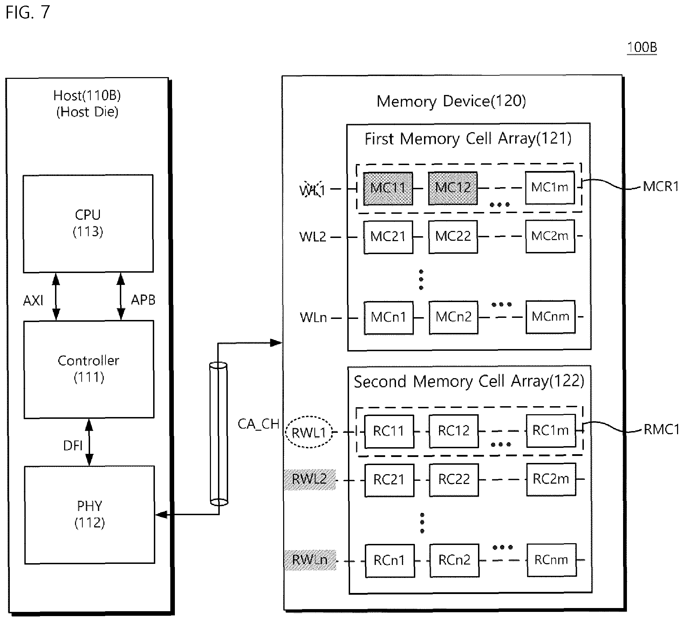

FIG. 7 is a block diagram illustrating the semiconductor device 100B in which the first word line is blocked according to one or more example embodiments of the disclosure.

Referring to FIG. 7, the controller 111 may block the first word line WL1 in response to the occurrence of the second type of error, which is uncorrectable through the ECC, in the first memory cell array 121.

In more detail, the controller 111 may block the first word line WL1 in response to the occurrence of the second type of error in the first memory cell row MCR1.

In the present embodiment, it is assumed that the controller 111 is capable of correcting a 1-bit error occurring in the certain memory cell row using the ECC.

As an example, when a total of 2-bit error occurs in the first-first memory cell MC11 and the first-second memory cell MC12, the controller 111 may determine that the second type of error occurs in the first memory cell row MCR1.

Further, the controller 111 may determine whether the first redundancy memory cell row RMC1 corresponding to the first memory cell row MCR1 exists or is available in the second memory cell array 122.

When the first redundancy memory cell row RMC1 exists in the second memory cell array 122, the controller 111 may deactivate the first word line WL1. In addition, the controller 111 may activate the first redundancy word line RWL1.

In addition, the controller 111 may write data in the first redundancy memory cell row RMC1 and may read data from the first redundancy memory cell row RMC1.

When the data written in the first redundancy memory cell row RMC1 are substantially the same as the data read from the first redundancy memory cell row RMC1, the controller 111 may determine that the error does not occur in the first redundancy memory cell row RMC1.

When it is determined that the error does not occur in the first redundancy memory cell row RMC1, the controller 111 may block the first word line WL1.

Further, the controller 111 may cut off the power supplied to the memory device 120 after activating the first redundancy word line RWL1 and blocking the first word line WL1.

That is, when it is possible to replace the first memory cell row MCR1 with the first redundancy memory cell row RMC1, the controller 111 may activate the first redundancy word line RWL1 and may block the first word line WL1.

Accordingly, the reliability of the memory device 120 of the semiconductor device 100B may be improved.

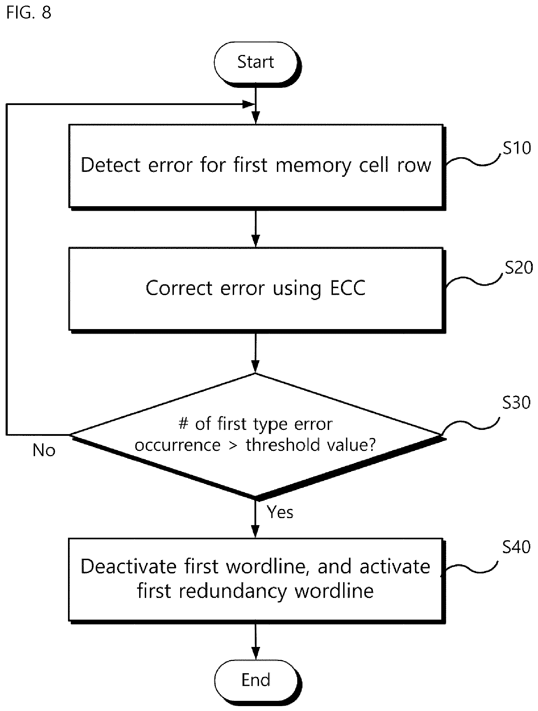

FIG. 8 is a flowchart illustrating a method of repairing the memory device according to one or more example embodiments of the disclosure.

Referring to FIG. 8, the controller 111 (or the host 110) may replace the memory cell row in which the error occurs a number of times exceeding the threshold value with the redundancy memory cell row.

In detail, when the number of the first type of errors occurring in the first memory cell row MCR1 exceeds the threshold value, the controller 111 may deactivate the first word line WL1.

In addition, the controller 111 may activate the first redundancy word line RWL1 corresponding to the first word line WL1. In this case, the first redundancy word line RWL1 may be connected to the first redundancy memory cell RMC1.

In operation S10, the controller 111 may detect the error occurring in the first memory cell row MCR1.

In detail, the controller 111 may detect whether the first type of error that is correctable using the ECC occurs in the first memory cell row MCR1.

As an example, the controller 111 may determine whether a number of a bit that have an error in the first memory cell row MCR1 is equal to or less than a number of a bit (e.g., "1") correctable through the ECC.

In the present embodiment, the controller 111 may write data in and may read the data from at least one of the first memory cells MC11 to MCnm included in the first memory cell row MCR1.

When the data written in a certain memory cell and the data read from the certain memory cell are different from each other, the controller 111 may determine that the error occurs in the certain memory cell.

That is, the controller 111 may determine whether a number of memory cells having an error among the first memory cells MC11 to MCnm included in the first memory cell row MCR1 is equal to or less than a number of memory cells having an error, which is correctable through the ECC.

In operation S20, the controller 111 may correct the error using the ECC.

In detail, the controller 111 may correct the error in response to the occurrence of the first type of error in the first memory cell row MCR1.

As an example, the controller 111 may correct the error occurring in the first-first memory cell MC11 using the ECC in response to the occurrence of the error in the first-first memory cell MC11 of the first memory cell row MCR1.

In operation S30, the controller 111 may determine whether the number of occurrences of the first type of error in the first memory cell row MCR1 exceeds the threshold value.

The controller 111 may determine whether the number of occurrences of the first type of error that is correctable using the ECC in the first memory cell row MCR1 exceeds a predetermined threshold value.

The controller 111 may determine whether a number of corrections for the error in the first memory cell row MCR1 using the ECC exceeds the threshold value.

In operation S40, the controller 111 may deactivate the first word line WL1 and may activate the first redundancy word line RWL1.

In detail, when the number of the first type of errors occurring in the first memory cell row MCR1 exceeds the threshold value, the controller 111 may deactivate the first word line WL1 connected to the first memory cell row MCR1. In addition, the controller 111 may activate the first redundancy word line RWL1 corresponding to the first word line WL1.

Accordingly, the controller 111 may replace the first memory cell row MCR1 with the first redundancy memory cell row RMC1.

That is, the controller 111 may write data in the first-first redundancy memory cell RC11 instead of the first-first memory cell MC11 and/or may read data from the first-first redundancy memory cell RC11 instead of the first-first memory cell MC11.

Based on the above-described configuration, when the number of the first type of error, which is correctable through the ECC, occurring in the first memory cell row MCR1, exceeds the threshold value, the controller 111 may deactivate the first word line WL1.

In addition, the controller 111 may activate the first redundancy word line RWL1 corresponding to the first word line WL1.

That is, the controller 111 may replace the first memory cell row MCR1 in which the error of the first type occurs more than the threshold value of times with the first redundancy memory cell row RMC1 without the physical disconnection or fusing operation.

Accordingly, the controller 111 may reduce the probability of the occurrence of the second type of error that is uncorrectable through the ECC in the memory device 120.

Further, the controller 111 may reduce the number of times the controller 111 blocks the power supplied to the memory device 120 to correct the second type of error occurring in the memory device 120. Accordingly, the controller 111 may reduce the performance degradation of the memory device 120 caused by cutting off the power supplied to the memory device 120.

As described above, the reliability of the memory device 120 of the semiconductor device 100 may be improved. In addition, the performance of the memory device 120 of the semiconductor devices 100 may be improved.

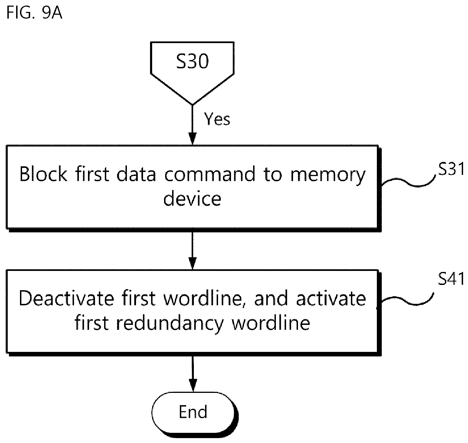

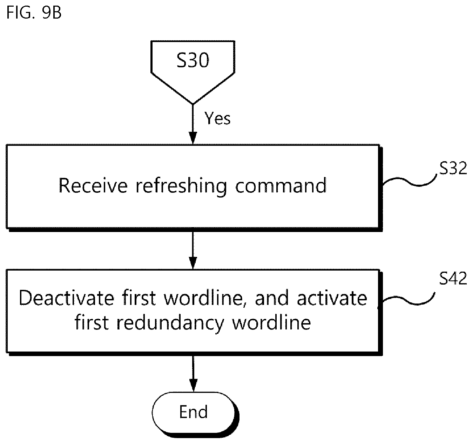

FIG. 9A is a flowchart illustrating a method of deactivating the first word line and activating the first redundancy word line after the first memory cell row is transitioned to the idle state according to one or more example embodiments of the disclosure. FIG. 9B is a flowchart illustrating a method of deactivating the first word line and activating the first redundancy word line in response to the self-refresh command according to one or more example embodiments of the disclosure.

Referring to FIG. 9A, the controller 111 may control the first memory cell row MCR1 to be in the idle state.

In operation S31, the controller 111 may block the first data command applied to the memory device 120 in response to the number of occurrences of the first type of error in the first memory cell row MCR1 exceeding the threshold value.

In detail, when the number of the first type of errors occurring in the first memory cell row MCR1 exceeds the threshold value, the controller 111 may block the data DQ and the data command DC applied to the first memory cell row MCR1 to transition the first memory cell row MCR1 to the idle state.

In operation S41, the controller 111 may deactivate the first word line WL1 and may activate the first redundancy word line RWL1.

In detail, the controller 111 may deactivate the first word line WL1 and may activate the first redundancy word line RWL1 in response to the transition of the first memory cell row MCR1 to the idle state.

That is, the controller 111 may deactivate the first word line WL1 and may activate the first redundancy word line RWL1 after determining that the first memory cell row MCR1 is transitioned to the idle state.

Accordingly, the reliability of the memory device 120 of the semiconductor device 100 may be improved.

On the other hand, according to one or more example embodiments of FIG. 9B, the controller 111 may deactivate the first word line WL1 and may activate the first redundancy word line RWL1 in response to the self-refresh command RFC provided from the CPU 113.

In operation S32, the controller 111 may receive the self-refresh command RFC from the CPU 113 in a state where the number of the first type of errors occurring in the first memory cell row MCR1 exceeds the threshold value.

In the present embodiment, the self-refresh command RFC may be the command to control the memory device 120 to operate in the self-refreshing mode, in which the memory device 120 performs the refresh operation on its own to maintain data while the host 110 is turned-off.

In operation S42, the controller 111 may deactivate the first word line WL1 and may activate the first redundancy word line RWL1.

In detail, the controller 111 may deactivate the first word line WL1 in response to the self-refresh command RFC provided from the CPU 113. In addition, the controller 111 may activate the first redundancy word line RWL1.

According to the above, the controller 111 may replace the first memory cell row MCR1 with the first redundancy memory cell row RMC1 before (or immediately before) the memory device 120 operates in the self-refreshing mode.

Therefore, the controller 111 may reduce the frequency of transitioning the first memory cell row MCR1 to the idle state to replace the first memory cell row MCR1 with the first redundancy memory cell row RMC1.

Accordingly, the semiconductor device 100 may reduce the performance degradation that is caused when at least a portion of the memory device 120 is transitioned to the idle state. That is, the reliability of the memory device 120 of the semiconductor device 100 may be improved.

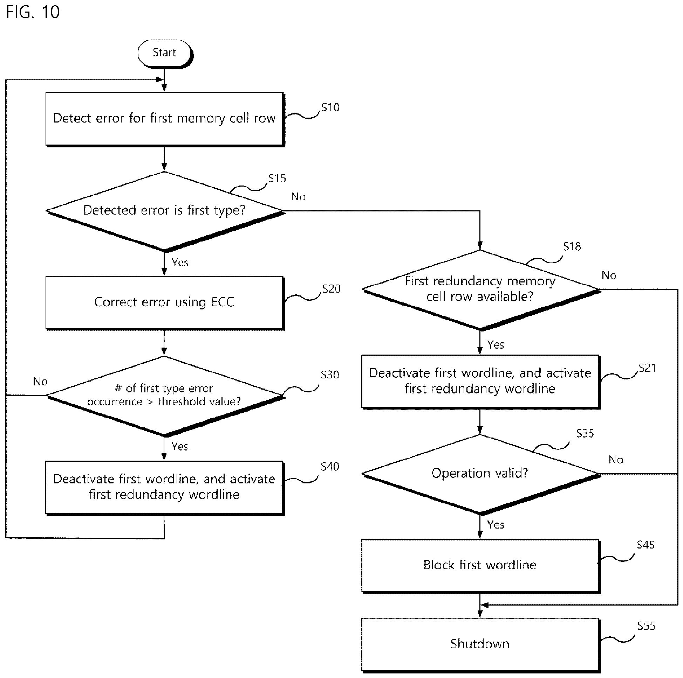

FIG. 10 is a flowchart illustrating a method of repairing the memory device depending on the type of error according to one or more example embodiments of the disclosure.

Referring to FIG. 10, the controller 111 (or the host 110) may correct the error depending on the type and the number of errors occurring in the first memory cell row MCR1.

The repairing method shown in FIG. 10 may include at least a portion of the operations described with reference to FIG. 8. Accordingly, descriptions that are the same or substantially the same as the above descriptions will be omitted.

In operation S10, the controller 111 may detect the error occurring in the first memory cell row MCR1.

In operation S15, the controller 111 may determine whether the error occurring in the first memory cell row MCR1 is the first type of error.

In detail, the controller 111 may determine whether the error occurring in the first memory cell row MCR1 is the first type of error that is correctable using the ECC.

As an example, the controller 111 may determine whether the number of a bit having an error in the first memory cell row MCR1 is equal to or less than a number of a bit correctable through the ECC.

In operation S18, when it is determined that the error occurring in the first memory cell row MCR1 is not the first type of error, the controller 111 may determine whether the first redundancy memory cell row RMC1 corresponding to the first memory cell row MCR1 is available.

In detail, when the second type of error occurs in the first memory cell row MCR1, the controller 111 may determine whether the first redundancy memory cell row RMC1 corresponding to the first memory cell row MCR1 is available (or exists).

In this case, the second type of error may be the uncorrectable error using the ECC.

That is, when a number of a bit (e.g., "2") having an error in the first memory cell row MCR1 is greater than a number of a bit (e.g. "1") that is correctable using the ECC, the controller 111 may determine whether the first redundancy memory cell row RMC1 is available (or exists).

In operation S21, the controller 111 may deactivate the first word line WL1 and may activate the first redundancy word line RWL1.

In detail, when it is determined that the first redundancy memory cell row RMC1 is available, the controller 111 may deactivate the first word line WL1 and may activate the first redundancy word line RWL1.

In operation S35, the controller 111 may determine whether the operation of the memory device 120 is valid.

In detail, the controller 111 may determine whether the operation of the memory device 120 is valid in the state where the first word line WL1 is deactivated and the first redundancy word line RWL1 corresponding to the first word line WL1 is activated.

As an example, the controller 111 may write data in the first-first redundancy memory cell row RC11 and may read the data from the first-first redundancy memory cell RC11.

When the data written in the first-first redundancy memory cell RC11 are the same as the data read from the first-first redundancy memory cell RC11, the controller 111 may determine that the first-first redundancy memory cell RC11 operates validly (or normally).

Further, when the redundancy memory cells RC11 to RC1m connected to the first redundancy memory cell row RMC1 normally operate, the controller 111 may determine that the first redundancy memory cell row RMC1 normally operates.

In operation S45, the controller 111 may block the first word line WL1.

In detail, when it is determined that the first redundancy memory cell row RMC1 normally operates, the controller 111 may block the first word line WL1.

In the present embodiment, the operation of blocking the first word line WL1 by the controller 111 may be the operation of physically disconnecting the path connected between the host 110 and the first word line WL1.

In addition, when the controller 111 blocks the first word line WL1 to physically disconnect the path connected between the host 110 and the first word line WL1, the controller 111 may use the first redundancy word line RWL1 by permanently replacing the first word line WL1.

Accordingly, the operation of blocking the first word line WL1 by the controller 111 may be referred to as the fusing operation.

Further, in operation S55, the controller 111 may shut down the memory device 120.

In more detail, the controller 111 may cut off the power supplied to the memory device 120 in response to the blocking of the first word line WL1.

According to the above, when the error that is uncorrectable using the ECC occurs in the first memory cell row MCR1, the controller 111 may replace the first memory cell row MCR1 with the first redundancy memory cell row RMC1.

Accordingly, the reliability of the memory device 120 of the semiconductor device 100 may be improved.

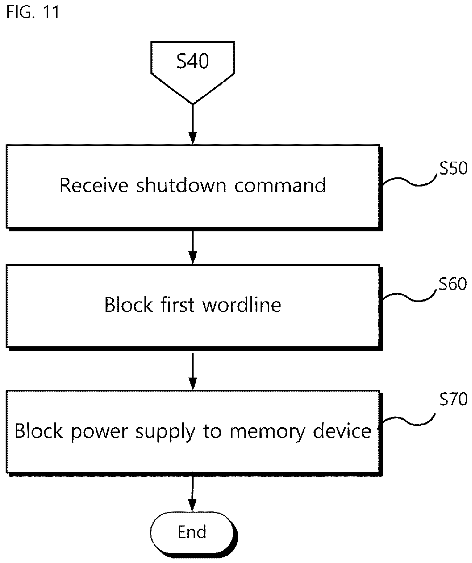

FIG. 11 is a flowchart illustrating operations of blocking the first word line and cutting off the power supplied to the memory device in response to the shutdown command according to one or more example embodiments of the disclosure.

Referring to FIG. 11, when the power supplied to the memory device 120 is cut off, the controller 111 (or the host 110) may block the first word line WL1.

In operation S50, the controller 111 may receive the shutdown command SDC.

In detail, the controller 111 may receive the shutdown command SDC from the CPU 113 in a state where the first word line WL1 is deactivated and the first redundancy word line RWL1 is activated.

The shutdown command SDC may serve as the command to cut off the power supplied to the memory device 120.

In operation S60, the controller 111 may block the first word line WL1 in response to the shutdown command SDC applied thereto from the CPU 113.

As an example, the controller 111 may disconnect the connection between the host 110 and the first word line WL1 in response to the shutdown command SDC applied thereto from the CPU 113.

In operation S70, the controller 111 may cut off the power supplied to the memory device 120.

In detail, the controller 111 may disconnect the connection between the host 110 and the first word line WL1 and then may cut off the power supplied to the memory device 120.

That is, in a state where the word line connected to the memory cell row in which the number of occurrences of the first type of error exceeds the threshold value is deactivated, the controller 111 may block the deactivated word line in response to the shutdown of the memory device 120.

Accordingly, the controller 111 may reduce the probability of the error occurring when the memory device 120 restarts after being shut down.

Thus, the reliability of the memory device 120 of the semiconductor device 100 may be improved.

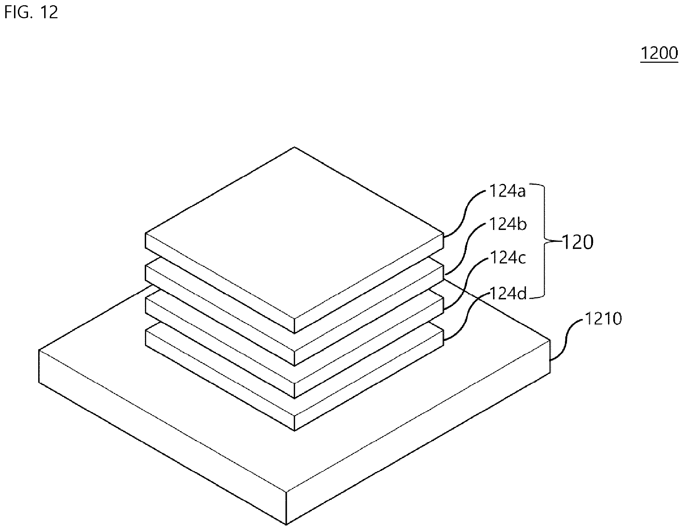

FIG. 12 is a perspective view illustrating a semiconductor device 1200 according to one or more example embodiments of the disclosure.

Referring to FIG. 12, the semiconductor device 1200 may include a host die 1210 and a memory device 120.

In the present embodiment, the semiconductor device 1200 shown in FIG. 12 may be substantially the same as the semiconductor device 100 shown in FIG. 1. In addition, the host die 1210 shown in FIG. 12 may be substantially the same as the host 110 shown in FIG. 1.

Accordingly, in FIG. 12, the same reference numerals may denote the same elements in FIG. 1, and thus, detailed descriptions of the same or substantially the same elements will be omitted.

In detail, the semiconductor device 1200 may include the host die 1210 to control the memory device 120.

In addition, the semiconductor device 1200 may include the memory device 120 disposed on one surface of the host die 1210.

The semiconductor device 1200 may include the memory device 120 disposed on the one surface of the host die 1210 and connected to the host die 1210.

The memory device 120 may include a plurality of memory dies 124a, 124b, 124c, and 124d stacked on the one surface of the host die 1210.

Accordingly, the memory device 120 may be referred to as a high bandwidth memory (HBM) including the memory dies 124a, 124b, 124c, and 124d stacked on one another. In addition, each of the memory dies 124a, 124b, 124c, and 124d may be referred to as an HBM DRAM device.

In addition, a structure of the semiconductor device 1200 may be referred to as a three-dimensional (3D) HBM in which the HBM is disposed on the one surface of the host die 1210.

In the present embodiment, each of the memory dies 124a, 124b, 124c, and 124d may be connected to the host die 1210 through a plurality of through silicon vias (TSVs).

Referring to FIGS. 2A and 12, the memory dies 124a, 124b, 124c, and 124d may transmit and receive at least one of the repair command RPC, the data command DC, the address ADDR, and the data DQ to and from the host die 1210 through the command/address channel CA_CH.

As the host die 1210 is connected to the memory device 120 through the command/address channel CA_CH, the host die 1210 may determine whether one or more memory cells (or one or more memory cell rows) of the memory device 120 are in the idle state.

Accordingly, the host die 1210 may determine whether the one or more memory cell rows in which the error (e.g., the second type of error) occurs are in the idle state to replace the one or more memory cell rows of the memory device 120 with one or more corresponding redundancy memory cells row during the operation of the semiconductor device 1200.

In addition, the host die 1210 may control the one or more memory cell rows of the memory device 120 to be in the idle state during the operation of the semiconductor device 1200.

According to the above, the host die 1210 may replace the one or more memory cell rows in which the error occurs with the one or more corresponding redundancy memory cell rows in response to the occurrence of the error in the one or more memory cell rows of the memory device 120 during the operation of the semiconductor device 1200.

Thus, the reliability of the memory device 120 of the semiconductor device 1200 may be improved.

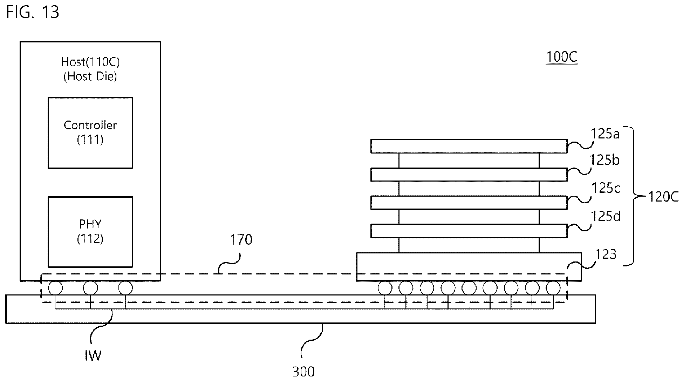

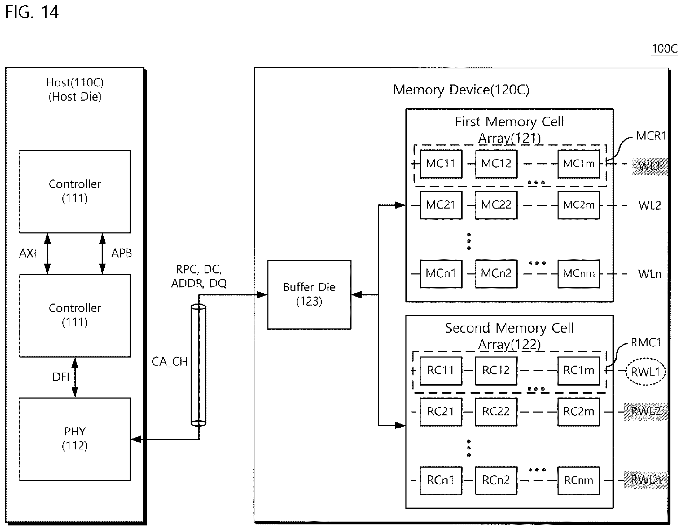

FIG. 13 is a cross-sectional view illustrating a semiconductor device 100C that corrects an error of a memory device 120C, according to one or more example embodiments of the disclosure. FIG. 14 is a block diagram illustrating the semiconductor device 100C according to one or more example embodiments.

Referring to FIGS. 13 and 14, the semiconductor device 100C may include a host 110C and the memory device 120C.

Referring to FIG. 13, the host 110C and the memory device 120C may be mounted on an interposer 300. In detail, the host 110C and the memory device 120C may be mounted on the interposer 300 using a plurality of bumps 170.

According to the present embodiment, the host 110C and the memory device 120C may be mounted on one surface of the interposer 300.

According to one or more example embodiments, the host 110C may be mounted on a first surface of the interposer 300, and the memory device 120C may be mounted on a second surface of the interposer 300, the second surface being substantially parallel to the first surface of the interposer 300.

The host 110C may be connected to the memory device 120C through the interposer 300.

The host 110C may be referred to as a host die or a logic die and may be implemented as a system-on-chip (SoC).

The host 110C may execute an application supported by the semiconductor device 100C using the memory device 120C. Accordingly, the host 110C may be referred to as an application processor (AP).

To this end, the host 110C may include a controller 111 to control an operation of the memory device 120. The controller 111 may control the memory device 120C and may perform various data input/output (I/O) operations on the memory device 120C. As an example, the controller 111 may access the memory device 120C using a direct memory access (DMA) method.

The host 110C may include a PHY 112 connected to the memory device 120C and the controller 111. The PHY 112 may transmit a data signal to the memory device 120C from the controller 111 through the interposer 300. As an example, the PHY 112 may transmit at least one of a data command, an address, a clock, and other control signals to memory device 120C through the interposer 300. In addition, the PHY 112 may receive a data signal from the memory device 120C through the interposer 300.

In addition, the memory device 120C may be electrically connected to the PHY 112 of the host 110C through the interposer 300. The memory device 120C may receive the data signal or may transmit the data signal through the interposer 300. In addition, the memory device 120C may receive the command, the address, the clock, or the other control signals through the interposer 300.

To this end, the interposer 300 may include a path (or a bus) through which the data signal is transmitted. As an example, the interposer 300 may include at least one internal wiring (IW) that connects the host 110C and the memory device 120C.

The memory device 120C may include a buffer die 123 and a plurality of memory dies 125a, 125b, 125c, and 125d.

In detail, the memory device 120C may include the buffer die 123 disposed on the interposer 300 and the memory dies 125a, 125b, 125c, and 125d stacked on the buffer die 123.

The memory device 120C may be a high bandwidth memory (HBM) including the memory dies 125a, 125b, 125c, and 125d stacked on the buffer die 123. In addition, the memory dies 125a, 125b, 125c, and 125d may be referred to as an HBM DRAM device.

However, according to one or more example embodiments, the memory device 120C may include a volatile memory device such as a static random access memory (SRAM) or a nonvolatile memory device, such as a phase-change random access memory (PRAM) device, a magnetoresistive random access memory (MRAM) device, a ferroelectric random access memory (FeRAM) device, a resistive random access memory (RRAM) device, or the like.

The interposer 300 may include, for example, silicon, but it should not be limited thereto or thereby.

Referring to FIG. 14, when a first type of error that is correctable through an ECC occurs in a first memory cell row MCR1 of a first memory cell array 121, the controller 111 (or the host 110C) may correct the error using the ECC.

As an example, the first type of error may be the error that occurs in a number of a bit equal to or less than the maximum number of a bit that is correctable through the ECC by the controller 111.

As an example, when a 1-bit error occurs in the first memory cell row MCR1 of the first memory cell array 121, the controller 111 may correct the error using the ECC. In this case, it is assumed that the controller 111 is capable of correcting the 1-bit error using the ECC.

When the number of the first type of errors occurring in the first memory cell row MCR1 exceeds a threshold value, the controller 111 may replace the first memory cell row MCR1 with a first redundancy memory cell row RMC1.

When the number of the first type of errors occurring in the first memory cell row MCR1 exceeds the threshold value, the controller 111 may replace the first memory cell row MCR1 with the first redundancy memory cell row RMC1 corresponding to the first memory cell row MCR1.

In detail, the controller 111 may deactivate a first word line WL1 connected to the first memory cell row MCR1. In addition, the controller 111 may activate a first redundancy word line RWL1 corresponding to the first word line WL1.

Accordingly, the controller 111 may replace the first memory cell row MCR1 with the first redundancy memory cell row RMC1.

On the other hand, according to one or more example embodiments, when a second type of error that is uncorrectable through the ECC occurs in the first memory cell row MCR1, the controller 111 may disconnect (or block) the first word line WL1.

In the present embodiment, the second type of error may be an error that occurs in a number of a bit exceeding the maximum number of a bit correctable through the ECC by the controller 111, but the second type of error should not be limited thereto or thereby.

In addition, the operation of blocking the first word line WL1 by the controller 111 may be the operation that physically disconnects a path connected between the host 110C and the first word line WL1 through the buffer die 123.

Accordingly, the operation of blocking the first word line WL1 by the controller 111 may be referred to as the fusing operation.

In addition, the controller 111 may activate the first redundancy word line RWL1 corresponding to the first word line WL1.

Further, the controller 111 may cut off the power supplied to the memory device 120C in response to the disconnection of the first word line WL1.

That is, when the second type of error occurs in the first memory cell row MCR1, the controller 111 may write or read data using the first redundancy memory cell row RMC1 instead of the first memory cell row MCR1.

Based on the above-described configuration, when the number of the first type of error, which is correctable through the ECC, occurring in the first memory cell row MCR1 exceeds the threshold value, the controller 111 may deactivate the first word line WL1.

In addition, the controller 111 may activate the first redundancy word line RWL1 corresponding to the first word line WL1.

That is, the controller 111 may replace the first memory cell row MCR1 with the first redundancy memory cell row RMC1 based on an occurrence of the first type of error that is correctable through the ECC without the physical disconnection or fusing operation.

Accordingly, the controller 111 may reduce the probability of an occurrence of the second type of error that is uncorrectable through the ECC in the memory device 120C.

Further, the controller 111 may reduce the number of times the controller 111 blocks the power supplied to the memory device 120C to correct the second type of error occurring in the memory device 120C. Accordingly, the controller 111 may reduce the performance degradation of the memory device 120C caused by cutting off the power supplied to the memory device 120C.

As described above, the reliability of the memory device 120C of the semiconductor device 100 may be improved.

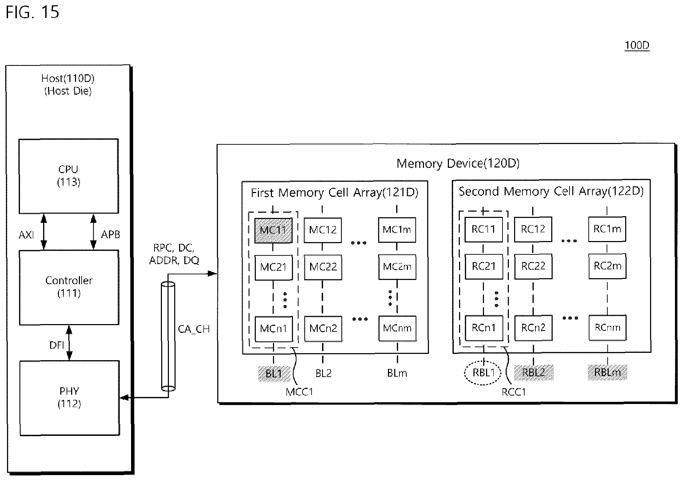

FIG. 15 is a block diagram illustrating a semiconductor device 100D according to one or more example embodiments of the disclosure.

Referring to FIG. 15, the semiconductor device 100D may include a host 110D and a memory device 120D.

The semiconductor device 100D shown in FIG. 15 may be an example of the semiconductor device 100 shown in FIG. 1.

Accordingly, the semiconductor device 100D shown in FIG. 15 may be substantially the same as the semiconductor device 100 shown in FIG. 1, and thus, detailed descriptions of the same or substantially the same elements will be omitted.

In detail, the semiconductor device 100D may include the host 110D configured to control the memory device 120D.

The host 110D may write data in the memory device 120D or may read the data from the memory device 120D.

In addition, the semiconductor device 100D may include the memory device 120D configured to store data. In addition, the memory device 120D may output the stored data in response to a read request from the outside.

The memory device 120D may be a dynamic random access memory (DRAM).

The memory device 120D may include a first memory cell array 121D and a second memory cell array 122D.

In detail, the memory device 120D may include the first memory cell array 121D corresponding to a plurality of bit lines BL1, BL2, ... BLm. In addition, the memory device 120D may include the second memory cell array 122D corresponding to a plurality of the redundancy bit lines RBL1, RBL2, ... RBLm.

As an example, the first memory cell array 121D may include a first memory cell column MCC1 corresponding to a first bit line BL1. In addition, the first memory cell column MCC1 may include a plurality of first memory cells MC11, MC21, ... MCn1 connected to the first bit line BL1.

In addition, the second memory cell array 122D may include a first redundancy memory cell column RCC1 corresponding to a first redundancy bit line RBL1. Further, the first redundancy memory cell column RCC1 may include a plurality of first redundancy memory cells RC11, RC21, ... RCn1 connected to the first redundancy bit line RBL1.

When a first type of error that is correctable through an ECC occurs in the first memory cell column MCC1 of the first memory cell array 121D, a controller 111 (or the host 110D) may correct the error using the ECC.

As an example, the first type of error may be the error that occurs in a number of a bit equal to or less than a maximum number of a bit that is correctable through the ECC by the controller 111.

When a number of the first type of errors occurring in the first memory cell column MCC1 exceeds a threshold value, the controller 111 may replace the first memory cell column MCC1 with the first redundancy memory cell column RCC1.

When the number of the first type of errors occurring in the first memory cell column MCC1 exceeds the threshold value, the controller 111 may replace the first memory cell column MCC1 with the first redundancy memory cell column RCC1 corresponding to the first memory cell column MCC1.

In more detail, the controller 111 may deactivate the first bit line BL1 connected to the first memory cell column MCC1. In addition, the controller 111 may activate the first redundancy bit line RBL1 corresponding to the first bit line BL1.

Accordingly, the controller 111 may replace the first memory cell column MCC1 with the first redundancy memory cell column RCC1.

On the other hand, according to one or more example embodiments, when a second type of error that is uncorrectable through the ECC occurs in the first memory cell column MCC1, the controller 111 may block the first bit line BL1.

In the present embodiment, the second type of error may be the error that occurs in a number of a bit exceeding the maximum number of a bit correctable through the ECC by the controller 111, but it should not be limited thereto or thereby.

In addition, the operation of blocking the first bit line BL1 by the controller 111 may be the operation that physically disconnects a path connected between the host 110D and the first bit line BL1.

Accordingly, the operation of blocking the first bit line BL1 by the controller 111 may be referred to as the fusing operation.

In addition, the controller 111 may activate the first redundancy bit line RBL1 corresponding to the first bit line BL1.

Further, the controller 111 may cut off the power supplied to the memory device 120D in response to the disconnection of the first bit line BL1.

That is, when the second type of error occurs in the first memory cell column MCC1, the controller 111 may write or read data using the first redundancy memory cell column RCC1 instead of the first memory cell column MCC1.

Based on the above-described configuration, when the number of the first type of errors occurring in the first memory cell column MCC1 exceeds the threshold value, the controller 111 may deactivate the first bit line BL1.

In addition, the controller 111 may activate the first redundancy bit line RBL1 corresponding to the first bit line BL1.

That is, the controller 111 may replace the first memory cell column MCC1 with the first redundancy memory cell column RCC1 based on an occurrence of the first type of error that is correctable through the ECC without the physical disconnection or fusing operation.

Accordingly, the controller 111 may reduce the probability of an occurrence of the second type of error that is uncorrectable through the ECC in the memory device 120D.

Further, the controller 111 may reduce the number of times the controller 111 blocks the power supplied to the memory device 120D to correct the second type of error occurring in the memory device 120D. Accordingly, the controller 111 may reduce the performance degradation of the memory device 120D caused by cutting off the power supplied to the memory device 120D.

As described above, the reliability of the memory device 120D of the semiconductor device 100D may be improved.

As describe above, referring back to FIGS. 1-7, when the number of the first type of error occurring in the first memory cell row MCR1 exceeds the threshold value, the controller 111 (or the host 110) may deactivate the first word line WL1.

In addition, the controller 111 may activate the first redundancy word line RWL1 corresponding to the first word line WL1.

That is, the controller 111 may replace the first memory cell row MCR1 with the first redundancy memory cell row RMC1 based on an occurrence of the first type of error that is correctable through the ECC without the physical disconnection or fusing operation.

Accordingly, the controller 111 may reduce the probability of an occurrence of the second type of error that is uncorrectable through the ECC in the memory device 120.

Further, the controller 111 may reduce the number of times the controller 111 blocks the power supplied to the memory device 120 to correct the second type of error occurring in the memory device 120.

Accordingly, the controller 111 may reduce the performance degradation of the memory device 120 caused by cutting off the power supplied to the memory device 120.

As described above, the reliability of the memory device 120 of the semiconductor device 100 may be improved. In addition, the performance of the memory device 120 of the semiconductor device 100 may be improved.

In addition, according to the above, the controller 111 may replace the first memory cell row MCR1 with the first redundancy memory cell row RMC1 before (or immediately before) the memory device 120 operates in the self-refreshing mode.

Accordingly, the controller 111 may reduce the frequency of transitioning the first memory cell row MCR1 to the idle state to replace the first memory cell row MCR1 with the first redundancy memory cell row RMC1.

Accordingly, the semiconductor device 100 may reduce the performance degradation caused by the transitioning of at least the portion of the memory device 120 to the idle state. That is, the reliability of the memory device 120 of the semiconductor device 100 may be improved.

While the disclosure has been described with reference to example embodiments thereof, it will be apparent to those of ordinary skill in the art that various changes and modifications may be made thereto without departing from the scope of the disclosure as set forth in the following claims and their equivalents.

Embodiments are set out in the following clauses:
Clause 1. A semiconductor device comprising:
   a host; and
   a memory device comprising a first memory cell array corresponding to a plurality of word lines and a second memory cell array corresponding to a plurality of redundancy word lines,
   wherein the host is configured to:
   detect an error occurring in a first memory cell row connected to a first word line of the first memory cell array; and
   based on a number of an occurrence of a first type of error, which is correctable through an error correction code, in the first memory cell row exceeding a predetermined threshold value, deactivate the first word line and activate a first redundancy word line corresponding to the first word line among the plurality of redundancy word lines.
Clause 2. The semiconductor device of clause 1, wherein the host is configured to, based on the detected error being of the first type, correct the first type of error in the first memory cell row using the error correction code.
Clause 3. The semiconductor device of clause 1 or clause 2, wherein the host comprises a controller configured to control an operation of the memory device, and
   wherein the controller is configured to, based on the number of the occurrence of the first type of error exceeding the predetermined threshold value, block a first data command from being applied to the memory device, deactivate the first word line, and activate the first redundancy word line based on the first memory cell row being in an idle state.
Clause 4. The semiconductor device of clause 3, wherein the memory device comprises a plurality of memory dies stacked one another, and the host comprises a physical layer configured to transmit and receive a repair command, a data command, an address, and data to and from the plurality of memory dies through a command/address channel.
Clause 5. The semiconductor device of clause 3 or clause 4, wherein the host further comprises a central processing unit to control an operation of the host, and
   wherein the controller is configured to, based on the number of the occurrence of the first type of error in the first memory cell row exceeding the predetermined threshold value, deactivate the first word line and activate the first redundancy word line in response to a self-refresh command applied from the central processing unit.

## Claims

1. A semiconductor device comprising:
a host; and
a memory device comprising a first memory cell array corresponding to a plurality of word lines and a second memory cell array corresponding to a plurality of redundancy word lines,
wherein the host is configured to, based on an occurrence of a first type of error that is correctable through an error correction code (ECC) in a first memory cell row connected to a first word line in the first memory cell array, correct the first type of error through the error correction code, and
wherein the host is configured to, based on a number of the occurrence of the first type of error in the first memory cell row exceeding a predetermined threshold value, deactivate the first word line and activate a first redundancy word line corresponding to the first word line among the plurality of redundancy word lines.

2. The semiconductor device of claim 1, wherein the host comprises:
a controller configured to control an operation of the memory device; and
a physical layer connected between the controller and the memory device, the physical layer being configured to transmit and receive a repair command, a data command, an address, and data to and from the memory device through a command/address channel.

3. The semiconductor device of claim 2, wherein the controller is configured to, based on the number of the occurrence of the first type of error in the first memory cell row exceeding the predetermined threshold value, determine whether the first memory cell row is in an idle state, and
wherein the controller is configured to, based on a determination that the first memory cell row is in the idle state, deactivate the first word line and activate the first redundancy word line.

4. The semiconductor device of claim 3, wherein the controller is configured to, based on a determination that the first memory cell row is not in the idle state, block a first data command from being applied to the first memory cell row to allow the first memory cell row to transition to the idle state.

5. The semiconductor device of any of claims 2-4, wherein the host further comprises a central processing unit, and the controller is configured to, based on the number of the occurrence of the first type of error in the first memory cell row exceeding the predetermined threshold value, deactivate the first word line and activate the first redundancy word line in response to a self-refresh command provided from the central processing unit.

6. The semiconductor device of any of claims 2-5, wherein the controller is configured to block the first word line and cut off a power supplied to the memory device based on an occurrence of a second type of error that is uncorrectable through the ECC in the first memory cell row.

7. The semiconductor device of claim 6, wherein the controller is configured to, based on the occurrence of the second type of error in the first memory cell row, deactivate the first word line and activate the first redundancy word line, and block the first word line based on data written in a first redundancy memory cell row connected to the first redundancy word line of the second memory cell array being equal to data read from the first redundancy memory cell row.

8. The semiconductor device of claim 7, wherein the controller is configured to, based on the occurrence of the second type of error in the first memory cell row, determine whether the first redundancy memory cell row corresponding to the first memory cell row is available in the second memory cell array and activate the first redundancy word line connected to the first redundancy memory cell row based on a determination that the first redundancy memory cell row available.

9. The semiconductor device of any of claims 5-8, wherein the controller is configured to, in a state in which the first word line is deactivated and the first redundancy word line is activated, block the first word line in response to a shutdown command provided from the central processing unit and cut off a power supplied to the memory device.

10. The semiconductor device of any preceding claim, wherein the memory device comprises a plurality of memory dies.

11. A method of repairing a memory device, comprising:
detecting an occurrence of an error in a first memory cell row connected to a first word line of a first memory cell array included in the memory device;
correcting, based on the detected error being of a first type that is correctable through an error correction code (ECC), the first type of error through the error correction code; and
deactivating the first word line and activating a first redundancy word line corresponding to the first word line, based on a number of an occurrence of the first type of error in the first memory cell row exceeding a predetermined threshold value.

12. The method of claim 11, further comprising:
blocking a first data command from being applied to the memory device, based on the number of the occurrence of the first type of error in the first memory cell row exceeding the predetermined threshold value; and
deactivating the first word line and activating the first redundancy word line, based on the first memory cell row being in an idle state.

13. The method of claim 11 or claim 12, further comprising deactivating the first word line and activating the first redundancy word line in response to a self-refresh command provided from a central processing unit, based on the number of the occurrence of the first type of error in the first memory cell row exceeding the predetermined threshold value.

14. The method of any of claims 11-13, further comprising:
deactivating the first word line and activating the first redundancy word line, based on the detected error being of a second type that is uncorrectable through the error correction code; and
blocking the first word line, based on data written in a first redundancy memory cell row connected to the first redundancy word line being equal to data read from the first redundancy memory cell row.

15. The method of claim 13 or claim 14, further comprising:
in a state in which the first word line is deactivated and the first redundancy word line is activated, blocking the first word line in response to a shutdown command output from the central processing unit; and
cutting off a power supplied to the memory device.
